(19) Europäisches Patentamt
European Patent Office
Office européen des brevets

(11) EP 1 092 174 B1

(12) **EUROPEAN PATENT SPECIFICATION**

(45) Date of publication and mention of the grant of the patent: **19.03.2003 Bulletin 2003/12**

(21) Application number: **99933498.0**

(22) Date of filing: **08.06.1999**

(51) Int Cl.[7]: **G03F 7/038**, G03F 7/033, C08L 53/02, C08F 297/04, C08F 8/00

(86) International application number: **PCT/US99/12788**

(87) International publication number: **WO 99/064931 (16.12.1999 Gazette 1999/50)**

(54) **PHOTOCURABLE ELASTOMERIC POLYMERS**

PHOTOHÄRTENDE ELASTOMERE POLYMERE

POLYMERS ELASTOMERES PHOTODURCISSABLES

(84) Designated Contracting States: **BE CH DE ES FR GB IT LI NL SE**

(30) Priority: **11.06.1998 US 88923 P**

(43) Date of publication of application: **18.04.2001 Bulletin 2001/16**

(73) Proprietor: **Dow Global Technologies Inc.**
**Midland, Michigan 48674 (US)**

(72) Inventors:
- **UZEE, Andre, J.**
  **Baton Rouge, LA 70820 (US)**
- **ESNEAULT, Calvin, P.**
  **Baton Rouge, LA 70816 (US)**
- **MYERS, Michael, O.**
  **Baton Rouge, LA 70808 (US)**

(74) Representative: **Raynor, John et al**
**W.H. Beck, Greener & Co**
**7 Stone Buildings**
**Lincoln's Inn**
**London WC2A 3SZ (GB)**

(56) References cited:
**EP-A- 0 353 471**
**GB-A- 1 432 783**
**GB-A- 1 556 585**
**GB-A- 2 195 349**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 092 174 B1

## Description

This application claims the benefit of U.S. Provisional Application Serial No. 60/088,923, filed June 11,1998.

This invention relates to photo-curable elastomeric compositions and highly reactive polymers useful in photo-curable elastomeric compositions. More specifically, this invention relates to photo-curable compositions that utilize solvent-soluble thermoplastic elastomers having addition-polymerizable vinylic endgroups or other reactive endgroups to provide for faster cross-linking (that is, curing) rates and lower solvent swell, while yielding softness and flexibility of the cured composition.

It is known in the art to use unsaturated, elastomeric polymers, such as styrenic block copolymers, in conjunction with an addition polymerization initiator activatable by actinic light in UV-active or photo-sensitive compositions. Examples of such compositions are found in U.S. Patent No. 3,674,486 issued to Milgrom, et al. ("Milgrom"); U.S. Patent No. 4,323,636 issued to Chen ("Chen"); U.S. Patent No. 4,686,172 issued to Woms, et al. ("Woms"); and U.S. Patent No. 5,582,954 issued to Swatton, et al. ("Swatton"). These UV-active compositions find utility in preparing printing plates, particularly flexographic printing plates, and other relief images.

Milgrom teaches the forming of a printing plate by compounding an elastomeric resin with a photosensitizing agent and a cross-linking agent. The elastomeric resin used in Milgrom is an unvulcanized elastomeric block copolymer comprising multiple blocks of two different polymer segments (for example, styrene and polybutadiene or polyisoprene).

Chen teaches a photosensitive composition comprising a solvent-soluble, thermoplastic, elastomeric, A-B-A block copolymer; at least one compatible, addition-polymerizable, ethylenically unsaturated compound containing one or two terminal ethylenic groups; and polymerization-effective amounts of an addition-polymerization initiator activatable by actinic radiation. Chen also teaches that printing reliefs can be made by forming the photosensitive compositions into a photosensitive layer and exposing selected portions or areas of the photosensitive layer to actinic radiation through an image-bearing transparency or stencil until substantial addition-polymerization or photo cross-linking takes place. In such a manner, the ethylenically unsaturated compound is polymerized or cross-linked in the radiation-exposed portions of the photosensitive layer with no significant polymerization or cross-linking taking place in the unexposed portions or areas of the photosensitive layer. The polymerization or cross-linking in the exposed portions causes reduced solubility or swellability in developer solvents. The unexposed portions of the layer can be removed by means of a solvent for the thermoplastic elastomer (that is, a developer solvent). Chen teaches that some residual unsaturation is desired in the thermoplastic elastomer, as olefinic carbon-carbon double bonds are well-known to undergo addition polymerization. However, Chen lists as cross-linking agents only those agents with addition-polymerizable ethylenically unsaturated compounds which have a vinyl structure, that is, those whose polymerizable groups have at least one double bond substituent which is not a pure hydrocarbon. Examples of useful compounds are those with acrylate and methacrylate groups.

Woms teaches a photosensitive elastomeric composition that exhibits high cure rates and exceptional softness. The composition disclosed in Woms comprises two polymers. The first polymer is an elastomeric diene polymer having a number average molecular weight of 30,000 to 125,000, with a Mooney viscosity of 35 or higher. The second polymer is a diene polymer having a number average molecular weight of 1,000 to 25,000. While this mixture of polymers may provide softness, the polymers have only olefinic double-bonds as the addition-polymerizable groups located in the polymer chain available for the required cross-linking which then insures insolubility upon irradiation.

In Swatton, it is taught that premixing polymer binders, such as the elastomeric block copolymers taught in Chen, with a liquid plasticizer and a petroleum wax can substantially increase the radiation exposure latitude of photohardenable layers that comprise such a premix. Exposure latitude is defined as the difference between the maximum and minimum exposure times needed to produce acceptable relief images. The maximum exposure time is usually defined as the maximum amount of time that selected portions of a photosensitive or photohardenable layer can be exposed to radiation without causing non-selected portions to cross-link or harden. The minimum exposure time is usually defined as the amount of radiation-exposure time needed to cause all the selected portions to cross-link or harden.

There is still a need in the industry to lower the minimum exposure time in photo-curable mixtures. Photo-curable mixtures having lower minimum exposure times will likely find utility in other applications in addition to production of flexographic printing plates and other relief images. It is also desirable in the industry to maintain or improve the dimensional stability to solvent (that is, resistance to solvent "swell") in cured or cross-linked compositions while maintaining or improving the softness.

It has been found that vinylic groups can be attached to the terminus (that is, endgroups) of thermoplastic elastomers that are typically used in photo-curable compositions. It has also been found that thermoplastic elastomers containing these endgroups perform better in photo-curable compositions than similar thermoplastic elastomers containing none of these groups.

The present invention provides a photo-curable elastomeric polymer, wherein the polymer:

a) is unsaturated;

b) has a number average molecular weight of at least 30,000; and

c) has a reactive endgroup at the alpha-or omega-terminus of the polymer, wherein the reactive endgroup is one capable of free-radical addition polymerization, copolymerization, oligomerization or dimerization initiated by a photo-initiator in the presence of actinic radiation and

d) is of the form I-A-B-A-R, wherein I is the residue from an organolithium initiator, A is a styrene polymer block, B is a polymer block of butadiene and/or isoprene, and R is a reactive endgroup at the omega terminus of the polymer, wherein the reactive endgroup is one capable of free-radical addition polymerization, co-polymerization, oligomerization or dimerization initiated by a photo-initiator in the presence of actinic radiation. Photo-curable compositions of the present invention exhibit faster cross-linking (that is, curing) rates (that is, lower minimum exposure times) than similar compositions containing no endgroup-modified polymers. Cured compositions prepared from the compositions exhibit lower solvent swell, and similar or increased softness (that is, lower hardness as measured by Short A hardness) when compared to cured compositions containing no unsaturated, high molecular weight, endgroup-modified polymers. The increased softness (or lower hardness) relates to improved flexibility of the cured compositions.

The present invention is concerned with unsaturated, high molecular weight, endgroup-modified polymers. By endgroup-modified, it is meant that polymers of the present invention have a vinyl or other reactive group, which is not a pure olefin, present at the alpha- or omega- terminus of the polymer (that is, a reactive endgroup). By reactive, it is meant that the endgroup is one capable of free-radical addition polymerization, co-polymerization, oligomerization or dimerization initiated by a photo-initiator in the presence of actinic radiation. These polymers are useful in photo-curable compositions and may find utility in other applications such as thermosetting adhesives.

Unsaturated, high molecular weight, endgroup-modified polymers of the present invention can be prepared by anionic polymerization, followed by capping or termination of the resulting living polymer with a functionalizing reagent, or with two or more reagents added sequentially. Polymerization is initiated by contacting a monomer or monomers with an alkali metal hydrocarbon initiator in an inert solvent or diluent. At the end of the polymerization sequence, the living polymer can be modified by terminating the living polymer with a suitable reagent that adds a functional or reactive group to the end of the polymer chain and provides additional or alternative reactive sites. Alternately, the living polymer can be first capped with a reagent to reduce the reactivity of the anionic living polymer, or otherwise make the termination step more selective, and then terminating with an appropriate addition reagent.

Photo-curable compositions of the present invention comprise (a) an elastomeric component containing one or more unsaturated, high molecular weight, endgroup-modified polymers; (b) a photopolymerization initiating system; optionally (c) one or more cross-linking agents; and optionally (d) other additives. In the present specification, all composition percentages are based on weight unless expressly stated otherwise.

The elastomeric component, which may be a blend of polymers, contains one or more unsaturated, high molecular weight, endgroup-modified polymers. The elastomeric component may contain other polymers, such as those found in photo-curable compositions of the prior art.

Typically, at least 10 per cent by weight of the polymers present in the elastomeric component will be unsaturated, high molecular weight, endgroup-modified polymers of the present invention. The amount and kind of other polymers that may be included in the elastomeric component can be determined without undue experimentation by one of ordinary skill in the art.

Also, elastomeric components of the present invention may contain oils. It is known In the industry that the kinds of polymers useful in the elastomeric component are often mixed with oil before being sold. When these polymers mixed with oil are utilized in the elastomeric component, the oil also gets incorporated into the elastomeric component.

By unsaturated, it is meant that polymers of the present invention contain carbon-carbon double bonds other than those that may be contained in the endgroup. This unsaturation is of the olefinic type. That is, all substituents of the carbon-carbon double bond are either hydrogen or hydrocarbons, and this type of unsaturation is that typically found in polymers resulting from polymerization of monomers containing dienes (for example, isoprene and butadiene).

Polymers of the present invention are high molecular weight polymers. For purposes of this specification, molecular weight will mean number average molecular weight as measured by size exclusion chromatography on a polystyrene calibration basis. Commercially available polystyrene standards were used for calibration and the molecular weights of copolymers corrected according to Runyon, et al., J. Applied Polymer Science, Vol. 13, p. 2359 (1969) and Tung, L. H., J. Applied Polymer Science, Vol. 24, p. 953 (1979).

By high molecular weight, it is meant that the polymers of the present invention have a number average molecular weight greater than 30,000. Preferably, polymers of the present invention have a molecular weight greater than 50,000. More preferably, polymers of the present invention have a molecular weight greater than 70,000.

Polymers of the present invention are endgroup-modified. By endgroup-modified, it is meant that polymers of the present invention have a vinylic or other reactive group, which is not of the pure olefinic type, present at the

alpha- or omega- terminus of the polymer (that is, a reactive endgroup). By reactive, it is meant that the endgroup is one capable of free-radical addition polymerization, co-polymerization, oligomerization or dimerization initiated by a photo-initiator in the presence of actinic radiation.

General classes of reactive endgroups useful in the present invention include those with vinylic unsaturation, such as $\alpha,\beta$-unsaturated carbonyls. Specific endgroups include, but are not limited to, acrylates, alkylacrylates, maleates and fumarates (and derivatives thereof, including esters), itaconate, citraconate, vinyl ether, vinyl ester, cinnamate, gamma-ketoacrylate (and derivatives thereof), and maleimide. Some examples of these groups are illustrated below:

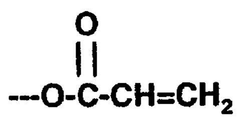
Acrylate

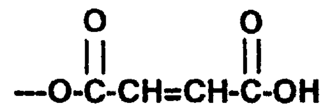
Maleate or Fumarate half-ester

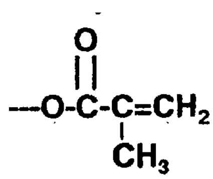
Methacrylate

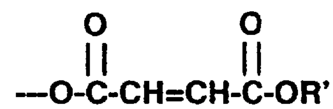
Maleate or Fumarate diester

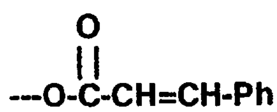
Cinnamate

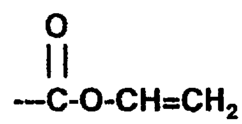
Vinyl Ester

$---O-CH=CH_2$

Vinyl Ether

Where R' = alkyl, aryl, substituted aryl and Ph = phenyl or substituted phenyl.

On a polystyrene calibration basis, block A has a molecular weight of at least 5,000; preferably, at least 7,000; and more preferably, at least 9,000. Blocks A and A' have a molecular weight of no more than 50,000; preferably, no more than 35,000; and more preferably, no more than 25,000. Block B has a molecular weight of at least 20,000; preferably, at least 40,000; and more preferably at least 60,000. Block B has a molecular weight of no more than 300,000; preferably, no more than 250,000; and more preferably, no more than 200,000. Polymers of the present invention have an overall molecular weight of at least 30,000; preferably, at least 50,000; and more preferably, at least 70,000. Polymers of the present invention have an overall molecular weight of no more than 300,000; preferably, no more than 250,000; and more preferably, no more than 200,000.

Photo-curable compositions of the present invention also include a photopolymerization initiating system. Photopolymerization initiating systems useful in the present invention are known in the art. Examples of useful photopolymerization initiating systems are taught in U.S. Patent No. 5,582,954; U.S. Patent No. 4,894,315; and U.S. Patent No. 4,460,675. Other typical agents performing this identical function can be found in EP 0696761A1 and US 468,172 and include such agents as benzephenone; 2,4,6-trimethylbenzophenone; 2-phenylanthraquinone; and 2-methyl-1-[4-(methylthio]phenyl]-2morpholinopropanone- 1.

Preferably, photo-curable compositions of the present invention will contain one or more cross-linking agents. Cross-linking agents useful in the present invention are known in the art. Examples of cross-linking agents include the list of ethylenically unsaturated cross-linking agents described in U.S. Patent No. 4,686,172.

Preferably, the cross-linking agents contained in photo-curable compositions of the present invention are photopolymerizable, ethylenically unsaturated, low molecular weight compounds. These compounds are also known in the art and include, for example, 1,6-hexandiol diacrylate and 1,6-hexandiol dimethacrylate. Other examples of such

compounds can be found in U.S. Patent No. 4,323,636; U.S. Patent No. 4,753,865; U.S. Patent No. 4,726,877; and U.S. Patent No. 4,894,315.

Preferred photo-curable mixtures of the present invention will contain from 0.1 per cent to 10 per cent, by weight, of photopolymerizable, ethylenically unsaturated, low molecular weight compounds. Utilizing less than 0.1 per cent of these compounds can result in photo-cured mixtures having too little cross-linking to be effective in some applications. Incorporating more than 10 per cent of these compounds in photo-curable mixtures of the present invention can lead to vaporization or surface exudation in cases where complete chemical bonding is not possible. This is especially true in applications such as the production of flexographic printing plates at elevated temperatures sufficient to induce polymer flow.

It is to be appreciated that typical photo-curable compositions of the present invention may also contain other additives, such as UV-sensitizing dyes, antioxidants, processing aids (for example, oils), plasticizers, ingredients enhancing ozone protection. Useful examples of some of these types of additives can be found in EP 0 696 761 Al and U.S. Patent No. 5,582,954.

Unsaturated, high molecular weight, endgroup-modified polymers of the present invention can be prepared by anionic polymerization, followed by capping or termination of the resulting living polymer with a functionalizing reagent, or with two or more reagents added sequentially. For purposes of the present specification, the phrase "living polymer" will refer to the polymer being produced as it exists during the anionic polymerization process. Examples of sequential polymerization processes that result in living block polymers after completion of polymerization are known in the prior art and include U.S. Patent No. 5,242,984; U.S. Patent No. 5,750,623; and Holden, et. al., Thermoplastic Elastomers, 2nd Edition, pages 51-53,1996.

Monomers useful in producing polymers of the present invention are those that are susceptible to anionic polymerization. These monomers are well-known in the art, these monomers are styrene; 1,3-butadiene; and isoprene.

Alkali metal hydrocarbon initiators suitable for anionic polymerization are well-known in the art. Examples of such initiators include, but are not limited to, lithium alkyls, sodium alkyls, and potassium alkyls. Preferred initiators are lithium alkyls, such as sec-butyllithium and n-butyllithium.

Solvents or diluents suitable for the polymerization are also well-known in the art. Examples included aromatic hydrocarbons, saturated aliphatic hydrocarbons, saturated cycloaliphatic hydrocarbons, linear ethers and cyclic ethers, and mixtures thereof. Preferred solvents or diluents are cyclohexane, n-hexane, and isopentane, and mixtures thereof.

Polymerization is initiated by contacting the monomer or monomers with an alkali metal hydrocarbon initiator in an inert solvent or diluent. Block copolymers can be produced by sequentially adding different monomers to the polymerization reaction mixture, as is known in the art.

At the end of the polymerization sequence, the living polymer can be modified by terminating the living polymer with a suitable reagent that adds a functional or reactive group to the end of the polymer chain and provides additional or alternative reactive sites. Alternately, the living polymer can be first capped with a reagent to reduce the reactivity of the anionic living polymer, or otherwise make the termination step more selective, and then terminating with an appropriate addition reagent.

The result after terminating with an appropriate reagent, as taught in the present invention, is a polymer with one or more terminal reactive or functional groups (that is, an endgroup-modified polymer). However, terminating with many other reagents results in simple hydrogen addition to the polymer (that is, hydrogen abstraction), which does not molecularly bind the remainder of the reagent to the polymer. Methods for modifying certain living polymers to result in a terminal reactive or functional group are known in the art, and are described in U.S. Patent No. 3,786,116 issued to Milkovich, et al.

Polymer #P1

To a 5 gallon stirred reactor under a nitrogen atmosphere were added 12.45 Kg of hydrocarbon solvent, which consisted of approximately 90 per cent cyclohexane and 10 per cent n-hexane by weight. For solvent purity, the reactor was blanked by adding 30 g of a cyclohexane solution which was 0.1195 molar in low molecular weight polystyryl lithium. At a temperature of 77.2°C, 43.7 g of a 0.284 molar solution of sec-butyllithium in cyclohexane solvent were added followed by 149.9 g of styrene. The polymerization was allowed to continue for 34 minutes, and then 1726.4 g of isoprene were added at 60°C which polymerized and reached a peak temperature of 86.4°C. At the end of 47 minutes, the temperature cooled to 78.4°C, and then 149.9 g of styrene monomer were added and allowed to polymerize for 31 minutes. To quench the reaction, 6 ml of isopropanol were added. After removal from the reactor, retained aliquots of solution were neutralized with phosphoric acid at a molar ratio of 0.3 mole acid per mole of lithium agent added per unit volume of liquor. Prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular

weight of 184,055 on a polystyrene calibration basis and a peak maximum at 185,959 on a polystyrene calibration basis. This polymer was identified as a styrene-isoprene-styrene ("SIS") triblock. This triblock polymer is indicative of prior art for high molecular weight block copolymers which contain no reactive endgroup.

Polymer #P2

To a 5 gallon stirred reactor under a nitrogen atmosphere were added 12.45 Kg of hydrocarbon solvent, which consisted of approximately 90 per cent cyclohexane and 10 per cent n-hexane by weight. For solvent purity, the reactor was blanked by adding 26 g of a cyclohexane solution which was 0.1195 molar in low molecular weight polystyryl lithium. At a temperature of 76.7°C, 36.3 g of a 0.284 molar solution of sec-butyllithium in cyclohexane solvent were added followed by 150.0 g of styrene. The polymerization was allowed to continue for 39 minutes, and then 1727.3 g of isoprene were added at 60°C which polymerized and reached a peak temperature of 90.2°C. At the end of 73 minutes, the temperature cooled to 79.3°C, and then 150.0 g of styrene monomer were added and allowed to polymerize for 31 minutes. To quench the reaction, 6 ml of isopropanol were added. After removal from the reactor, retained aliquots of solution were neutralized with phosphoric acid at a molar ratio of 0.3 mole acid per mole of lithium agent added per unit volume of liquor. Prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 235,261 on a polystyrene calibration basis and a peak maximum at 235,767 on a polystyrene calibration basis. This polymer was identified as a styrene-isoprene-styrene ("SIS") triblock. This triblock polymer is indicative of prior art for high molecular weight block copolymers which contain no reactive endgroup. This polymer differs from polymer P1 by having higher molecular weight.

Polymer #P3

To a 5 gallon stirred reactor under a nitrogen atmosphere were added 12.42 Kg of hydrocarbon solvent, which consisted of approximately 90 per cent cyclohexane and 10 per cent n-hexane by weight. For solvent purity, the reactor was blanked by adding 27 g of a cyclohexane solution which was 0.1195 molar in low molecular weight polystyryl lithium. At a temperature of 76.9°C, 79.4 g of a 0.284 molar solution of sec-butyllithium in cyclohexane solvent were added followed by 299.2 g of styrene. The polymerization was allowed to continue for 35 minutes, and then 1722.2 g of isoprene were added at 60°C, which polymerized and reached a peak temperature of 86.7°C. At the end of 45 minutes, 6 ml of isopropanol were added. After removal from the reactor, retained aliquots of solution were neutralized with phosphoric acid at a molar ratio of 0.3 mole acid per mole of lithium agent added per unit volume of liquor. Prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 102,679 on a polystyrene calibration basis and a peak maximum at 103,239 on a polystyrene calibration basis. This polymer was identified as a styrene-isoprene ("SI") diblock. This diblock polymer is indicative of prior art for high molecular weight block copolymers which contain no reactive endgroup.

Polymer #P4

To a 5 gallon stirred reactor under a nitrogen atmosphere were added 12.45 Kg of hydrocarbon solvent, which consisted of approximately 90 per cent cyclohexane and 10 per cent n-hexane by weight. For solvent purity, the reactor was blanked by adding 20 g of a cyclohexane solution which was 0.1195 molar in low molecular weight polystyryl lithium. At a temperature of 74.7°C, 43.7 g of a 0.284 molar solution of sec-butyllithium in cyclohexane solvent were added followed by 149.9 g of styrene. The polymerization was allowed to continue for 34 minutes, and then 1726.4 g of isoprene were added at 60°C which polymerized and reached a peak temperature of 84.7°C. At the end of 46 minutes, the temperature cooled to 77.7°C, and then 149.9 g of styrene monomer were added and allowed to polymerize for 63 minutes. Then 0.80 ml of ethylene oxide were added at a temperature of 73.1 °C and allowed to react for 77 minutes. Then 1.56 ml of methacryloyl chloride were added at a temperature of 70.5°C and allowed to react and quench the reaction for 66 minutes.

To convert any unreacted methacryloyl chloride, 6 ml of isopropanol were added. After removal from the reactor and prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 185,499 on a polystyrene calibration basis and a peak maximum at 185,959 on a polystyrene calibration basis. This polymer was identified as a styrene-isoprene-styrene triblock with a reactive endgroup ("R-SIS"). This polymer is most similar to polymer P1 except that the living polymer is capped with ethylene oxide and then reacted and quenched with methacryloyl chloride instead of being terminated by reaction with an alcohol. This polymer is representative of a block copolymer with a reactive endgroup in which the reactive living anionic end prior to capping with ethylene oxide and methacryloyl chloride is made from styrene monomer.

Polymer #P5

To a 5 gallon stirred reactor under a nitrogen atmosphere were added 12.45 Kg of hydrocarbon solvent, which consisted of approximately 90 per cent cyclohexane and 10 per cent n-hexane by weight. For solvent purity, the reactor was blanked by adding 38 g of a cyclohexane solution which was 0.1195 molar in low molecular weight polystyryl lithium. At a temperature of 76.4°C, 39.5 g of a 0.284 molar solution of sec-butyllithium in cyclohexane solvent were added followed by 150.0 g of styrene. The polymerization was allowed to continue for 35 minutes, and then 1726.9 g of isoprene were added at 60°C, which polymerized and reached a peak temperature of 82.9°C. At the end of 49 minutes, the temperature cooled to 78.2°C, and then 150.0 g of styrene monomer were added and allowed to polymerize for 32 minutes. Then 0.75 ml of ethylene oxide were added at a temperature of 70.8°C and allowed to react for 36 minutes. Then 1.41 ml of methacryloyl chloride were added at a temperature of 70.6°C and allowed to react and quench the reaction for 63 minutes.

To convert any unreacted methacryloyl chloride, 6 ml of isopropanol were added. After removal from the reactor and prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 217,710 on a polystyrene calibration basis and a peak maximum at 218,427 on a polystyrene calibration basis. This polymer was identified as a styrene-isoprene-styrene triblock with a reactive endgroup ("R-SIS"). This polymer is most similar to polymer P2, except that the current polymer P5 capped with ethylene oxide and then reacted with methacryloyl chloride instead of being terminated by reaction with an alcohol. This polymer is representative of a block copolymer with a reactive endgroup in which the reactive living anionic end prior to capping with ethylene oxide and methacryloyl chloride is made from styrene monomer.

Polymer #P6

To a 5 gallon stirred reactor under a nitrogen atmosphere were added 12.42 Kg of hydrocarbon solvent, which consisted of approximately 90 per cent cyclohexane and 10 per cent n-hexane by weight. For solvent purity, the reactor was blanked by adding 33 g of a cyclohexane solution which was 0.1195 molar in low molecular weight polystyryl lithium. At a temperature of 77.3°C, 79.4 g of a 0.284 molar solution of sec-butyllithium in cyclohexane solvent were added followed by 299.2 g of styrene. The polymerization was allowed to continue for 36 minutes, and then 1722.2 g of isoprene were added at 58.8°C, which polymerized and reached a peak temperature of 86°C. At the end of 70 minutes, the temperature cooled to 70.2°C. Then 1.45 ml of ethylene oxide were added and allowed to react for 31 minutes. Then 2.83 ml of methacryloyl chloride were added at a temperature of 69.6°C and allowed to react and quench the reaction for 60 minutes.

To convert any unreacted methacryloyl chloride, 6 ml of isopropanol were added. After removal from the reactor and prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 104,611 on a polystyrene calibration basis and a peak maximum at 106,009 on a polystyrene calibration basis. This polymer was identified as a styrene-isoprene diblock copolymer with a reactive endgroup ("R-SI"). This polymer is most similar to polymer P3, except that the current polymer P6 is capped with ethylene oxide and then reacted with methacryloyl chloride instead of being terminated by reaction with an alcohol. This polymer is representative of a block copolymer with a reactive endgroup in which the reactive living anionic end, prior to capping with ethylene oxide and methacryloyl chloride, is made from isoprene monomer.

Polymer #P7

To a 5 gallon stirred reactor under a nitrogen atmosphere were added 12.42 Kg of hydrocarbon solvent, which

consisted of approximately 90 per cent cyclohexane and 10 per cent n-hexane by weight. For solvent purity, the reactor was blanked by adding 27 g of a cyclohexane solution which was 0.1195 molar in low molecular weight polystyryl lithium. At a temperature of 59.6°C, 79.4 g of a 0.284 molar solution of sec-butyllithium in cyclohexane solvent were added followed by 1722.2 g of isoprene. The polymerization was allowed to continue for 47 minutes and reached a peak temperature of 91°C. After the temperature cooled to 77.6°C, 299.2 g of styrene monomer were added and allowed to polymerize for 67 minutes. Then 1.45 ml of ethylene oxide were added at a temperature of 70.4°C and allowed to react for 33 minutes. Then 2.83 ml of methacryloyl chloride were added at a temperature of 70°C and allowed to react and quench the reaction for 60 minutes.

To convert any unreacted methacryloyl chloride, 6 ml of isopropanol were added. After removal from the reactor and prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 100,357 on a polystyrene calibration basis and a peak maximum at 102,149 on a polystyrene calibration basis. This polymer was identified as a isoprene-styrene diblock copolymer with a reactive endgroup ("R-IS"). This polymer is similar to polymer P6, except that the current polymer P7 of the reaction monomer polymerization sequence is reversed so that the reactive living anionic end prior to capping with ethylene oxide and methacryloyl chloride is made from styrene monomer rather than isoprene monomer.

Polymer #P8

To a 5 gallon stirred reactor under a nitrogen atmosphere were added 12.45 Kg of hydrocarbon solvent which consisted of approximately 90 per cent cyclohexane and 10 per cent n-hexane by weight. For solvent purity, the reactor was blanked by adding 23 g of a cyclohexane solution which was 0.1195 molar in low molecular weight polystyryl lithium. At a temperature of 77.4°C, 43.7 g of a 0.284 molar solution of sec-butyllithium in cyclohexane solvent were added followed by 149.9 g of styrene. The polymerization was allowed to continue for 35 minutes, and then 1726.4 g of isoprene were added at 60°C which polymerized and reached a peak temperature of 87.5°C. At the end of 65 minutes, the temperature cooled to 77.6°C, and then 149.9 g of styrene monomer were added and allowed to polymerize for 65 minutes. Then 1.00 ml of ethylene oxide were added at a temperature of 70°C and allowed to react for 31 minutes. Then 3.2 g of maleic anhydride were added at a temperature of 70.5°C and allowed to react and quench the reaction for 65 minutes. Then, 2 ml of isopropanol were added.

After removal from the reactor and prior to recovery by devolatilization of volatile compounds in a vacuum oven set at 100°C for a minimum of 3 hours, phenolic antioxidant was added at a level of 1200 ppm of base polymer and phosphite antioxidant was added at a level of 1000 ppm of base polymer.

Analysis by size exclusion chromatography showed a single main peak with a number average molecular weight of 181,400 on a polystyrene calibration basis and a peak maximum at 183,021 on a polystyrene calibration basis. This polymer was identified as a styrene-isoprene-styrene triblock copolymer with a reactive endgroup ("R-SIS"). This polymer is most similar to polymer P4 except that the current polymer, after being capped with ethylene oxide, was reacted with maleic anhydride instead of methacryloyl chloride. This polymer is representative of a block copolymer with a reactive endgroup in which the reactive living anionic end, prior to capping with ethylene oxide and maleic anhydride, is made from styrene monomer.

Polymer #P9

Component A: To a 1136 liter stirred reactor under a nitrogen atmosphere were added 442.3 kg of a hydrocarbon solvent containing approximately 8 per cent to 15 per cent isopentane with the balance being cyclohexane solvent. For solvent purity, the reactor was blanked by adding 0.23 kg of a cyclohexane solution which was 0.0979 molar in low molecular weight polystyryl lithium. Then 406 g of a 1.3939 molar solution of sec-butyllithium in cyclohexane solvent were added. At a temperature of 67.3°C, 6.44 kg of styrene was added followed by a 34 kg hydrocarbon solvent purge of the styrene line. After allowing the polymerization to occur for 20 minutes, 77.2 kg of isoprene were added at a temperature of 69°C followed by 34 kg of hydrocarbon solvent for an isoprene line flush. A peak temperature of 81°C occurred, and 20 minutes after isoprene addition the temperature dropped to 72.6°C at which time 6.44 kg of styrene were added. A line flush of 34 kg of hydrocarbon solvent immediately followed the styrene addition. After 20 minutes reaction time, 40.7 ml of ethylene oxide were added and allowed to react for approximately 1 hour. Next, 86.8 ml of methacryloyl chloride which was pre-mixed with 200-300 ml of cyclohexane solvent, were added and allowed to quench the reaction for a period of approximately 1 hour. Finally, 15 g of isopropanol were added to react with any residual methacryloyl chloride. Analysis by size exclusion chromatography showed a single main peak with a number average molecular weight of 178,214 on a polystyrene calibration basis and a peak maxima at 194,051 on a polystyrene calibration basis. This polymer is representative of a block copolymer with a reactive endgroup, in which the reactive living anionic end prior to capping with ethylene oxide and methacryloyl chloride, is made from styrene monomer. This component was identified as a styrene-isoprene-styrene triblock with a reactive endgroup ("R-SIS"). The entire contents of the reactor were transferred to a mix tank for solution blending. Phenolic antioxidant was added at a level of 1200 ppm base polymer and phosphite antioxidant was added at a level of 1000 ppm.

Component B: To a 1136 liter stirred reactor under a nitrogen atmosphere were added 443.6 kg of a hydrocarbon solvent containing approximately 8 per cent to 15 per cent isopentane with the balance being cyclohexane solvent. For solvent purity, the reactor was blanked by adding 0.23 kg of a cyclohexane solution which was 0.0979 molar in low molecular weight polystyryl lithium. Then 406 g of a 1.3939 molar solution of sec-butyllithium in cyclohexane solvent were added. At a temperature of 70°C were added 6.44 kg of styrene followed by a 34 kg hydrocarbon solvent styrene line purge. After allowing the polymerization to occur for 20 minutes, 77.2 kg of isoprene were added at a temperature of 71.2°C followed by 34 kg of hydrocarbon solvent for an isoprene line flush. A peak temperature of 84°C occurred, and 20 minutes after the isoprene addition the temperature dropped to 73°C, at which time 6.44 kg of styrene were added. A line flush of 34 kg of hydrocarbon solvent immediately followed the styrene addition. After 20 minutes reaction time, 40.7 ml of ethylene oxide were added and allowed to react for approximately 1 hour. Next, 86.8 ml of methacryloyl chloride, which was pre-mixed with 200-300 ml of cyclohexane solvent, were added and allowed to quench the reaction for a period of approximately 1 hour. Finally, 15 g of isopropanol were added to react with any residual methacryloyl chloride. Analysis by size exclusion chromatography showed a single main peak with a number average molecular weight of 190,283 on a polystyrene calibration basis and a peak maxima at 194,051 on a polystyrene calibration basis. This polymer is representative of a block copolymer with a reactive endgroup in which the reactive living anionic end, prior to capping with ethylene oxide and methacryloyl chloride, is made from styrene monomer. This component was identified as a styrene-isoprene-styrene triblock with a reactive endgroup ("R-SIS"). The entire contents of the reactor were transferred to the mix tank containing component A for solution blending. Appropriate amounts of phenolic antioxidant were added for the contents of this component to produce a level of 1200 ppm base polymer and phosphite antioxidant was added at a level of 1000 ppm.

Component C: To a 1136 liter stirred reactor under a nitrogen atmosphere were added 304.3 kg of a hydrocarbon solvent containing approximately 8 per cent to 15 per cent isopentane with the balance being cyclohexane solvent. For solvent purity, the reactor was blanked by adding 0.23 kg of a cyclohexane solution which was 0.0979 molar in low molecular weight polystyryl lithium. Then 370.5 g of a 1.3939 molar solution of sec-butyllithium in cyclohexane solvent were added. At a temperature of 72°C were added 5.85 kg of styrene followed by a 34 kg hydrocarbon solvent purge. After allowing the polymerization to occur for 20 minutes, 35.2 kg of isoprene were added at a temperature of 72°C followed by 34 kg of hydrocarbon solvent for line flush. A peak temperature of 85°C occurred, and reaction was allowed to continue for 20 minutes. Then, 37.1 ml of ethylene oxide were added and allowed to react for approximately 1 hour. Next, 79.1 ml of methacryloyl chloride, which was pre-mixed with 200-300 ml of cyclohexane solvent, were added and allowed to quench the reaction for a period of approximately 1 hour. Finally, 30 g of isopropanol were added to react with any residual methacryloyl chloride. Analysis by size exclusion chromatography showed a single main peak with a number average molecular weight of 97,937 on a polystyrene calibration basis and a peak maximum at 98,941 on a polystyrene calibration basis. This polymer is representative of a block copolymer with a reactive endgroup in which the reactive living anionic end, prior to capping with ethylene oxide and methacryloyl chloride, is made from isoprene monomer. This component was identified as a styrene-isoprene diblock with a reactive endgroup ("R-SI"). The entire contents of the reactor were transferred to the mix tank containing component A and component B for solution blending. Appropriate amounts of phenolic antioxidant were added for the contents of this component to produce a level of 1200 ppm base polymer and phosphite antioxidant was added at a level of 1000 ppm.

Blended Mixture: Blending of components A, B, and C above produce a triblock/diblock blend with monomer composition, monomer sequencing, and segment molecular weights similar to tribtock/diblock blends that can be obtained by synthesis of styrene-isoprene diblock components via anionic chemistry, followed by coupling with a difunctional coupling agent. Based on monomer addition quantities, R-SI diblock content in this blend is calculated to be 18.6 per cent by weight. Analysis of this mixture by size exclusion chromatography showed two main peaks. The first peak had a number average molecular weight of 189,444 on a polystyrene calibration basis and a peak maximum at 190,972 on a polystyrene calibration basis. This is identified as the R-SIS triblock peak. The second peak had a number average molecular weight of 99,028 on a polystyrene calibration basis and a peak maximum at 99,469 on a polystyrene calibration basis. This is identified as the R-SI diblock peak. Based on integrated detector response areas, the analysis estimates diblock content to be 20.6 per cent. Final sample was recovered as a solid extruded pellet by removal of solvent using a twin-screw devolatilization extruder with melt temperature maximum of approximately 230°C. These pellets were identified as polymer P9 and analysis of these pellets by size exclusion chromatography showed two main peaks. The first peak had a number average molecular weight of 186,056 on a polystyrene calibration basis and a peak maximum at 186,950 on a polystyrene calibration basis. This is identified as the R-SIS triblock peak. The second peak had a number average molecular weight of 98,671 on a polystyrene calibration basis and a peak maximum at

99,469 on a polystyrene calibration basis. This is identified as the R-SI diblock peak. Based on integrated detector response areas, the analysis estimates diblock content to be 13.1 per cent. This polymer demonstrates a block copolymer with a reactive endgroup in which the reactive living anionic end, prior to capping with ethylene oxide and other appropriate reagents, is made from both the styrene monomer and the isoprene monomer.

Samples 1 through 10

Ten samples were prepared according to the weight compositions listed in Table I. Items A through F were individually pre-weighed as solids and added in sequence as described below. Items G and H were liquids and were added by volumetric measurement with graduated syringes and actual weight determined by mathematical conversion using room temperature density values (density: item g = 1.01 g/ml and item h = 0.995 g/ml). The polymer components listed are P1 through P9 and are those described above. In the current examples, ingredient C, IRGANOX® 1010 (CAS 6683-19-8), is an antioxidant available from Ciba-Geigy Corp. Ingredient D, CERESINE® Wax SP 252 (CAS 8001-75-0) is available from Strahl & Pitsch Inc. and is intended for ozone protection. Ingredient E, PICCOTEX® 100S hydrocarbon resin (CAS 8001-75-0), is a plasticizer resin available from Hercules Co.

Ingredient F, IRGACURE® 651 photoinitiator, is alpha, alpha-dimethoxy-alpha-phenylacetophenone (CAS 24650-42-8) and is available from Ciba-Geigy. Ingredients G and H are cross-linking agents. Ingredient G is 1,6-hexanediol dimethacrylate (CAS 6606-59-3) available from Aldrich Chemical Co., Inc. Ingredient H is 1,6,-hexandiol diacrylate (CAS 13048-33-4) available from Aldrich Chemical Co., Inc.

**Table I**

| | | Component | | | | | | | | | |
|---|---|---|---|---|---|---|---|---|---|---|---|
| | | A | | B | | C | D | E | F | G | H |
| Sample No. | Remark | Polymer A | Weight A (g) | Polymer B | Weight B (g) | Irganox 1010 (g) | Cerisine Wax (g) | PICCOTEX 100S (g) | IRGACURE 651 (g) | 1,6-hexanediol dimethacrylate (g) | 1,6-hexanediol diacrylate (g) |
| 1+ | SIS | P1 | 200 | --- | --- | 1 | 3 | 20 | 5.34 | 10 | 13.9 |
| 2+ | SIS/SI | P2 | 164 | P3 | 36 | 1 | 3 | 20 | 5.34 | 10 | 13.9 |
| 3 | SIS* | P4 Δ | 200 | --- | --- | 1 | 3 | 20 | 5.34 | 10 | 13.9 |
| 4+ | SIS*/SI* | P5 Δ | 164 | P6 | 36 | 1 | 3 | 20 | 5.34 | 10 | 13.9 |
| 5+ | SIS*/SI | P5 Δ | 164 | P3 | 36 | 1 | 3 | 20 | 5.34 | 10 | 13.9 |
| 6+ | SIS*/IS* | P5 Δ | 164 | P7 | 36 | 1 | 3 | 20 | 5.34 | 5 | 6.9 |
| 7+ | SIS*/SI* | P9 | 200 | --- | --- | 1 | 3 | 20 | 5.34 | 5 | 6.9 |
| 8 | SIS maleic | P8 Δ | 200 | --- | --- | 1 | 3 | 20 | 5.34 | 10 | 13.9 |
| 9+ | SIS/SI | P2 | 164 | P3 | 36 | 1 | 3 | 20 | 5.34 | 5 | 6.9 |
| 10+ | SIS*/SI* | P5 Δ | 164 | P6 | 36 | 1 | 3 | 20 | 5.34 | 5 | 6.9 |

maleic = capped with ethylene oxide and maleic anhydride

* = capped with ethylene oxide and methacrylovl chloride

+ comparative examples; Δ polymers of the invention.

The mixing procedure was as follows for all examples. Into a Mohrtek Model 1Z Double Arm Sigma Blade mixer (1 pint or 946 ml working capacity), which was pre-heated to 130°C, were added component A and component B (where needed) using several additions during which rotor blades were started and stopped in order to masticate the solid polymer and allow it to fit into the bowl. Immediately after introducing all the polymer (components A and B), components C, D, and E were added. The components were allowed to mix between 30 minutes and 1 hour but in no case was mixing stopped until the mixture was fluxed into a homogenous thermoplastic mass. During the mixing process, temperature was controlled at 130°C by an electrically heated and jacketed trough, and a positive flow of nitrogen gas was allowed to continuously purge the covered mixture trough. Upon determination of flux and after a minimum

of 30 minutes, component F was added and allowed to mix well for one to three minutes. Using an addition port covered by a rubber septum, a prescribed amount of component G was added followed within 2 minutes by a prescribed amount of component H. During addition of liquid components G and H, the mixer cover was closed and a slight nitrogen purge was continued. The complete mixture was fluxed for at least 8 to 10 minutes and then removed. The resultant bulk mass was flattened to less than 12 mm thickness by passing through a 3" x 7" Farrel Machinery Company dual-roll research mill (Model 3FF500) preheated to 130-135°C for less than 4 minutes or by pressing components between TEFLON® TFE-coated glass film sheets with a compression molding press (PHI Model SB234C-X-MSX24), which was heated to 130°C for less than 4 minutes. These materials were stored in envelopes not transparent to light and stored at room temperature until needed.

Data

Thin sheets approximately 75 mm in width by 115 mm in length by 0.90 mm in thickness were prepared by compression molding in the above compression molding press by pressing approximately 7.0 grams of finished compound above in a chase of above dimensions. Sheets of TFE-coated glass sheets were used to prevent sticking to the metal backing plates. The press protocol was to preheat the chase and components for 30 minutes at 130°C at minimal pressure, then press at 0.5 minute at 10,000 Kg ram force, then press for 3.0 minutes at 20,000 Kg ram force, then allow to slowly cool to below 50°C for 4.5 minutes at 20,000 Kg ram force. Sheets were continually stored without exposure to light until further treatment or testing.

Pressed sheets of above compounds were exposed to actinic radiation by passing specimens through a Fusion Systems Corporation W Curing System (Model 1300MB, Model F300-S lamp system, Type D Bulb, bench top conveyor). Exposure was controlled by controlling the number of passes at a constant belt speed. The belt speed was adjustable between 15 and 25 feet per minute and the exact speed was set based on readings from a calibrated exposure meter. The lamp was maintained at a constant intensity via on/off controls. Exposure was estimated by a pre-run to determine average dosage (total energy) recorded by a Model PP2000 Power Puck with certified calibration from the manufacturer (Miltec Corporation) via calibration by KIT Instrumentation Products via methods traceable to the National Institute of Standards (NIST). Dosage was determined prior to any extended exposure session. The per pass dosage was determined from the average of 4 passes of the test instrument. Belt speed was adjusted to bring total dosage for 4 passes to approximately 4.20 Joules/$cm^2$ for the spectral range of 320-390 nm (UV-A band). Sample sheets exposure was made with approximately half of exposure to one side of the sheet and the other half of the exposure to the reverse side. For example, an 8 pass sample would have 4 passes with each side facing the lamp.

After exposure, test specimens were die cut into rectangular shapes for swell testing, or into tensile specimens. For swell, either a 0.5 inch by 1.5 inch rectangle or a 0.5 inch by 2.5 inch rectangle were used. Swell testing was conducted by weighing initial sample weight before exposure, sample weight immediately after removal from a 2 ounce glass jar which contained 40 ml of toluene solvent and which had been shaken for at least 16 hours, and sample weight after drying the recovered specimen in a circulating air oven at 90°C until all solvent had been removed. These weights are defined as Weight (initial). Weight (swell), and Weight (final), respectively. Two ratios are defined as follows to characterize results:

$$\text{Swell Ratio} = \text{Weight (swell)}/\text{Weight (final)}$$

$$\text{Per Cent Retained} = \text{Weight (final)}/\text{Weight (initial)}$$

Shore A durometer hardness was determined according to ASTM D 2240 using a Model 716A Durometer Hardness System available from Shore Instruments. Exposed sheets were cut into squares approximately 1.5 inches square and stacked to at least a minimum of 0.25 inch height before testing. Elongation at break was determined in a manner similar to ASTM D 412-87 using ASTM 1822 Die L with 0.5 inch tabs, crosshead speed of 10 inches/minutes, and gauge marks set 1.0 inch apart. Ultimate elongation was determined visually by observing the actual gauge length at rupture, and four replicate pulls were averaged to yield the final value. In some instances, independent exposures were used for the swell sample rectangles and hardness test specimens and another independent exposure was used for specimens used for determination of elongation at break. In some examples, all samples were exposed simultaneously for each specific test condition. Exposure for samples are noted along with results in Table II. Based on observation, deviation between exposure for different sessions of exposure was controlled within a narrow range (< 2 per cent relative standard deviation), and therefore it is analogous to use the number of passes to accurately rank results.

TABLE II

| Sample No. | Passes (No.) | Weight (Initial) Grams | Weight (Swell) Grams | Weight (Final) Grams | Swell Ratio | % Retained | Exposure Dosage (J/ $cm^2$), Swell/ Hardness Specimen | Exposure Dosage (J/ $cm^2$) Elongation Specimen | Hardness (Shore A) | % Elongation |
|---|---|---|---|---|---|---|---|---|---|---|
| 1 | 0 | 0.451 | 0.000 | 0.000 | | 0.0 | 0.00 | 0.00 | 25.3 | 575 |
| 1 | 1 | 0.471 | 8.680 | 0.206 | 42.14 | 43.7 | 1.17 | 1.08 | | 975 |
| 1 | 2 | 0.436 | 8.436 | 0.238 | 35.55 | 54.6 | 2.35 | 2.16 | | 1050 |
| 1 | 3 | 0.477 | 5.320 | 0.322 | 16.52 | 67.5 | 3.52 | 3.23 | | 1100 |
| 1 | 4 | 0.448 | 4.930 | 0.377 | 13.08 | 84.2 | 4.69 | 4.21 | 46.6 | 975 |
| 1 | 8 | 0.479 | 3.380 | 0.413 | 8.18 | 86.2 | 9.38 | 8.42 | 49.9 | 806 |
| 1 | 12 | 0.476 | 2.720 | 0.421 | 6.46 | 88.4 | 14.08 | 12.94 | | 525 |
| 1 | 16 | 0.467 | 2.510 | 0.414 | 6.06 | 88.7 | 18.77 | 16.84 | 49.5 | 542 |
| | | | | | | | | | | |
| 2 | 0 | 0.442 | 0.000 | 0.000 | | 0.0 | 0.00 | 0.00 | | 742 |
| 2 | 1 | 0.387 | 4.250 | 0.090 | 47.2 | 23.3 | 1.08 | | | |
| 2 | 2 | 0.447 | 6.370 | 0.260 | 24.5 | 58.2 | 2.16 | 2.13 | | 1117 |
| 2 | 3 | 0.435 | 5.140 | 0.330 | 15.6 | 75.9 | 3.23 | 3.19 | | 1142 |
| 2 | 4 | 0.437 | 4.300 | 0.350 | 12.3 | 80.1 | 4.31 | 4.25 | | 1050 |
| 2 | 8 | 0.427 | 2.900 | 0.360 | 8.1 | 84.3 | 8.63 | 8.50 | 46.1 | 700 |
| 2 | 12 | 0.444 | 2.530 | 0.400 | 6.3 | 90.1 | 12.94 | | | |
| 2 | 16 | 0.407 | 2.350 | 0.340 | 6.9 | 83.5 | 17.25 | 17.00 | | 383 |
| | | | | | | | | | | |
| 3 | 0 | 0.472 | 0.000 | 0.000 | | 0.0 | 0.00 | 0.00 | 23.6 | 842 |
| 3 | 1 | 0.456 | 8.740 | 0.291 | 30.03 | 63.8 | 1.17 | 1.08 | | 1050 |
| 3 | 2 | 0.441 | 6.430 | 0.361 | 17.81 | 81.9 | 2.35 | 2.16 | | 1150 |
| 3 | 3 | 0.452 | 4.650 | 0.372 | 12.50 | 82.3 | 3.52 | 3.23 | | 983 |
| 3 | 4 | 0.424 | 3.540 | 0.351 | 10.09 | 82.8 | 4.69 | 4.21 | 45.5 | 933 |
| 3 | 8 | 0.426 | 2.510 | 0.373 | 6.73 | 87.6 | 9.38 | 8.42 | 48.0 | 638 |
| 3 | 12 | 0.437 | 2.320 | 0.388 | 5.98 | 88.8 | 14.08 | 12.94 | | 458 |
| 3 | 16 | 0.470 | 2.310 | 0.420 | 5.50 | 89.4 | 18.77 | 16.84 | 50.1 | 458 |
| | | | | | | | | | | |

TABLE II (continued)

| Sample No. | Passes (No.) | Weight (Initial) Grams | Weight (Swell) Grams | Weight (Final) Grams | Swell Ratio | % Retained | Exposure Dosage (J/ $cm^2$), Swell/ Hardness Specimen | Exposure Dosage (J/ $cm^2$) Elongation Specimen | Hardness (Shore A) | % Elongation |
|---|---|---|---|---|---|---|---|---|---|---|
| 4 | 0 | 0.682 | 0.000 | | | 0.0 | 0.00 | 0.00 | | 1117 |
| 4 | 1 | 0.703 | 8.200 | 0.200 | 41.0 | 28.4 | 1.08 | | | |
| 4 | 2 | 0.713 | 8.800 | 0.540 | 16.3 | 75.7 | 2.15 | 2.13 | | 1150 |
| 4 | 3 | 0.704 | 6.310 | 0.570 | 11.1 | 81.0 | 3.23 | 3.19 | | 1042 |
| 4 | 4 | 0.720 | 5.490 | 0.610 | 9.0 | 84.7 | 4.30 | 4.25 | | 967 |
| 4 | 8 | 0.718 | 4.350 | 0.620 | 7.0 | 86.4 | 8.60 | 8.50 | 44.6 | 583 |
| 4 | 12 | 0.717 | 4.000 | 0.630 | 6.3 | 87.9 | 12.90 | | | |
| 4 | 16 | 0.676 | 3.180 | 0.590 | 5.4 | 87.3 | 17.20 | 17.00 | | 408 |
| | | | | | | | | | | |
| 5 | 0 | 0.670 | 0.060 | | | 0.0 | 0.00 | 0.00 | | 1033 |
| 5 | 1 | 0.695 | 9.470 | 0.200 | 47.4 | 28.8 | 1.08 | | | |
| 5 | 2 | 0.640 | 8.080 | 0.460 | 17.6 | 71.9 | 2.15 | 2.13 | | 1100 |
| 5 | 3 | 0.694 | 6.970 | 0.550 | 12.7 | 79.3 | 3.23 | 3.19 | | 867 |
| 5 | 4 | 0.686 | 5.740 | 0.560 | 10.3 | 81.6 | 4.30 | 4.25 | | 783 |
| 5 | 8 | 0.665 | 4.550 | 0.570 | 8.0 | 85.7 | 8.60 | 8.50 | 43 | 633 |
| 5 | 12 | 0.705 | 4.270 | 0.600 | 7.1 | 85.1 | 12.90 | | | |
| 5 | 16 | 0.705 | 3.480 | 0.620 | 5.6 | 87.9 | 17.20 | 17.00 | | 467 |
| | | | | | | | | | | |
| 6 | 0 | 0.419 | 0.000 | | | 0.0 | 0.00 | 0.00 | | 908 |
| 6 | 2 | 0.452 | 4.140 | 0.331 | 12.51 | 73.2 | 2.13 | 2.13 | | 1067 |
| 6 | 3 | 0.438 | 4.035 | 0.343 | 11.76 | 78.3 | 3.19 | 3.19 | | 1100 |
| 6 | 4 | 0.414 | 3.270 | 0.337 | 9.70 | 81.5 | 4.25 | 4.25 | | 983 |
| 6 | 8 | 0.441 | 2.795 | 0.376 | 7.43 | 85.3 | 8.50 | 8.50 | 46 | 725 |
| 6 | 16 | 0.437 | 2.160 | 0.382 | 5.65 | 87.5 | 17.00 | 17.00 | | 517 |
| 7 | 0 | 0.400 | 0.000 | | | 0.0 | 0.00 | 0.00 | | 800 |
| 7 | 2 | 0.407 | 4.470 | 0.273 | 16.40 | 66.9 | 2.14 | 2.14 | | 1117 |
| 7 | 3 | 0.406 | 3.320 | 0.318 | 10.43 | 78.5 | 3.21 | 3.21 | | 1033 |
| 7 | 4 | 0.412 | 2.970 | 0.341 | 8.70 | 82.9 | 4.28 | 4.28 | | 833 |

TABLE II (continued)

| Sample No. | Passes (No.) | Weight (Initial) Grams | Weight (Swell) Grams | Weight (Final) Grams | Swell Ratio | % Retained | Exposure Dosage (J/ $cm^2$), Swell/ Hardness Specimen | Exposure Dosage (J/ $cm^2$) Elongation Specimen | Hardness (Shore A) | % Elongation |
|---|---|---|---|---|---|---|---|---|---|---|
| 7 | 8 | 0.402 | 2.370 | 0.346 | 6.85 | 86.2 | 8.55 | 8.55 | 50.0 | 633 |
| 7 | 12 | 0.405 | 2.150 | 0.353 | 6.09 | 87.1 | 12.83 | 12.83 | | 617 |
| 7 | 16 | 0.410 | 2.120 | 0.358 | 5.93 | 87.2 | 17.11 | 17.11 | | 475 |
| | | | | | | | | | | |
| 8 | 0 | 0.416 | 0.000 | | | 0 | 0.00 | 0.00 | | 708 |
| 8 | 2 | 0.396 | 4.546 | 0.262 | 17.4 | 66 | 2.05 | 2.05 | | 1083 |
| 8 | 3 | 0.413 | 3.785 | 0.315 | 12.0 | 76 | 3.08 | 3.08 | | 1058 |
| 8 | 4 | 0.391 | 3.282 | 0.319 | 10.3 | 82 | 4.11 | 4.11 | | 1033 |
| 8 | 8 | 0.417 | 2.546 | 0.363 | 7.0 | 87 | 8.21 | 8.21 | 50.3 | 758 |
| 8 | 12 | 0.391 | 2.036 | 0.344 | 5.9 | 88 | 12.32 | 12.32 | | 642 |
| | | | | | | | | | | |
| 9 | 0 | 0.404 | | | | 0 | 0.00 | 0.00 | | 1425 |
| 9 | 2 | 0.416 | 13.11 | 0.211 | 62.2 | 51 | 2.05 | 2.05 | | 1242 |
| 9 | 3 | 0.390 | 6.978 | 0.216 | 32.3 | 56 | 3.08 | 30.8 | | 1233 |
| 9 | 4 | 0.390 | 6.656 | 0.295 | 22.6 | 75 | 4.11 | 4.11 | | 1267 |
| 9 | 8 | 0.402 | 3.497 | 0.341 | 10.3 | 85 | 8.21 | 8.21 | 46.9 | 1008 |
| 9 | 12 | 0.402 | 2.894 | 0.344 | 8.4 | 85 | 12.32 | 12.32 | | 800 |
| 9 | 16 | 0.423 | 2.826 | 0.368 | 7.7 | 87 | 16.43 | 16.43 | | 717 |
| | | | | | | | | | | |
| 10 | 0 | 0.403 | | | | 0 | 0.00 | 0.00 | | 1313 |
| 10 | 2 | 0.399 | 8.678 | 0.224 | 38.8 | 56 | 2.05 | 2.05 | | 1283 |
| 10 | 3 | 0.395 | 5.682 | 0.256 | 22.2 | 65 | 3.08 | 30.8 | | 1283 |
| 10 | 4 | 0.414 | 5.637 | 0.312 | 18.1 | 75 | 4.11 | 4.11 | | 1267 |
| 10 | 8 | 0.412 | 3.286 | 0.350 | 9.4 | 85 | 8.21 | 8.21 | 44.1 | 1000 |
| 10 | 12 | 0.422 | 2.777 | 0.364 | 7.6 | 86 | 12.32 | 12.32 | | 783 |
| 10 | 16 | 0.397 | 2.576 | 0.343 | 7.5 | 86 | 16.43 | 16.43 | | 600 |

## Claims

1. A photo-curable elastomeric polymer, wherein the polymer:

   a) is unsaturated;
   b) has a number average molecular weight of at least 30,000; and
   c) has a reactive endgroup at the alpha-or omega-terminus of the polymer, wherein the reactive endgroup is one capable of free-radical addition polymerization, copolymerization, oligomerization or dimerization initiated by a photo-initiator in the presence of actinic radiation and
   d) is of the form I-A-B-A-R, wherein I is the residue from an organolithium initiator, A is a styrene polymer block, B is a polymer block of butadiene and/or isoprene, and R is a reactive endgroup at the omega terminus of the polymer, wherein the reactive endgroup is one capable of free-radical addition polymerization, co-polymerization, oligomerization or dimerization initiated by a photo-initiator in the presence of actinic radiation

2. A polymer according to Claim 1, wherein the polymer has a number average molecular weight of at least 50,000.

3. A polymer according to Claim 2, wherein the polymer has a number average molecular weight of at least 70,000.

4. A polymer according to Claim 1, wherein the reactive endgroup is an acrylate group, an alkylacrylate group, a methacrylate group, a maleate group, a fumarate group, a vinyl ether group, or a vinyl ester group.

5. A polymer according to Claim 1, wherein the reactive endgroup is an acrylate group, a methacrylate group, or a maleate group.

6. A polymer according to Claim 5, wherein:

   a) block A has a number average molecular weight of at least 5,000 and no more than 50,000; and
   b) block B has a number average molecular weight of at least 20,000 and no more than 300,000.

## Patentansprüche

1. Fotohärtbares elastomeres Polymer, wobei das Polymer:

   a) ungesättigt ist;
   b) ein zahlenmittleres Molekulargewicht von mindestens 30.000 aufweist und
   c) eine reaktive Endgruppe an dem alpha- oder omega-Ende des Polymers aufweist, wobei die reaktive Endgruppe eine ist. die zur radikalischen Additionspolymerisation. -copolymerisatlon. -oligomerisation oder -dimerisierung, die durch einen Fotoinitiator in Gegenwart von aktinischer Strahlung initiiert wird, fähig ist. und
   d) die Form I-A-B-A-R aufweist, worin I der Rest von einem Organolithluminitiator ist, A ein Styrolpolymerblock ist, B ein Polymerblock aus Butadien und/oder Isopren ist und R eine reaktive Endgruppe am omega-Ende des Polymers ist. wobei die reaktive Endgruppe eine ist, die zur radikalischen Additionspolymerisation, -copolymerisation. -oligomerisation oder -dimerisierung, die durch einen Fotoinitiator in Gegenwart von aktinischer Strahlung initiiert wird. fähig ist.

2. Polymer nach Anspruch 1, worin das Polymer ein zahlenmittleres Molekulargewicht von mindestens 50.000 aufweist.

3. Polymer nach Anspruch 2, worin das Polymer ein zahlenmittleres Molekulargewicht von mindestens 70.000 aufweist.

4. Polymer nach Anspruch 1, worin die reaktive Endgruppe eine Acrylatgruppe, eine Alkylacrylatgruppe, eine Methacrylatgruppe, eine Maleatgruppe, eine Fumaratgruppe, eine Vinylethergruppe oder eine Vinylestergruppe ist.

5. Polymer nach Anspruch 1. worin die reaktive Endgruppe eine Acrylatgruppe, eine Methacrylatgruppe oder eine Maleatgruppe ist.

6. Polymer nach Anspruch 5, worin:

a) Block A ein zahlenmittleres Molekulargewicht von mindestens 5.000 und nicht mehr als 50.000 aufweist und
b) Block B ein zahlenmittleres Molekulargewicht von mindestens 20.000 und nicht mehr als 300.000 aufweist.

**Revendications**

**1.** Polymère élastomère photodurcissable, dans lequel le polymère :

a) est insaturé ;
b) a un poids moléculaire moyen en nombre d'au moins 30 000 ; et
c) a un groupe terminal réactif à l'extrémité alpha ou oméga du polymère, où le groupe terminal réactif est un groupe capable de polymérisation d'addition radicalaire, de copolymérisation, d'oligomérisation ou de dimérisation amorcées par un photo-amorceur en présence de radiation actinique et
d) est de la forme I-A-B-A-R, où I est le résidu d'un amorceur organolithium, A est un bloc polymère de styrène, B est un bloc polymère de butadiène et/ou d'isoprène, et R est un groupe terminal réactif à l'extrémité oméga du polymère, où le groupe terminal réactif est un groupe capable de polymérisation d'addition radicalaire, de co-polymérisation, d'oligomérisation ou de dimérisation amorcées par un photo-amorceur en présence de radiation actinique.

**2.** Polymère selon la revendication 1, dans lequel le polymère a un poids moléculaire moyen en nombre d'au moins 50 000.

**3.** Polymère selon la revendication 2, dans lequel le polymère a un poids moléculaire moyen en nombre d'au moins 70 000.

**4.** Polymère selon la revendication 1, dans lequel le groupe terminal réactif est un groupe acrylate, un groupe alkylacrylate, un groupe méthacrylate, un groupe maléate, un groupe fumarate, un groupe éther vinylique, ou un groupe ester vinylique.

**5.** Polymère selon la revendication 1, dans lequel le groupe terminal réactif est un groupe acrylate, un groupe méthacrylate, ou un groupe maléate.

**6.** Polymère selon la revendication 5, dans lequel :

a) le bloc A a un poids moléculaire moyen en nombre d'au moins 5 000 et de pas plus de 50 000 ; et
b) le bloc B a un poids moléculaire moyen en nombre d'au moins 20 000 et de pas plus de 300 000.